# EUROPEAN PATENT APPLICATION

(11) **EP 3 611 544 A1**
(43) Date of publication of application: **19.02.2020**
(21) Application number: 18784315.6
(22) Date of filing: 07.02.2018
(51) Int. Cl.: G02B 3/00, C09J 7/20, C09J 163/00, G02B 1/04, G02B 7/02

(54) **OPTICAL COMPONENT ARRAY PROVIDED WITH ADHESIVE LAYER**

(30) Priority: 12.04.2017 JP 2017078632
(71) Applicant: Daicel Corporation, Osaka-shi, Osaka 530-0011 (JP)
(72) Inventor: FUJIKAWA, Takeshi, Himeji-shi Hyogo 671-1283 (JP); FUKUI, Sadayuki, Himeji-shi Hyogo 671-1283 (JP)
(74) Representative: Grünecker Patent- und Rechtsanwälte PartG mbB
(86) International application number: PCT/JP2018/004153
(87) International publication number: WO 2018/189989

(57) **Abstract**

The present invention is to provide an optical component array, that is, optical components arranged in an array, that can be directly affixed to a substrate, that allows easy adjustment of the distance between the optical components and the substrate by controlling a pressing force during the affixing, and that can adhere the optical components and the substrate by performing photoirradiation and/or heat treatment. The optical component array provided with an adhesive layer according to an embodiment of the present invention having a structure in which two or more optical components each having an adhesive layer having heat- or photo-curability and having a storage modulus at 25°C from 0.05 × 10⁴ to 10000 × 10⁴ Pa on at least a part of a surface are arranged.

## Description

### Technical Field

The present invention relates to an optical component array provided with an adhesive layer, a production method thereof, and a production method of an arrayed optical module using the optical component array provided with an adhesive layer. The present application claims priority to JP 2017-078632 A filed to Japan on April 12, 2017, and the content of which is incorporated herein.

### Background Art

In an LED module provided with a lens, it has been known that the distance between an LED element and the lens remarkably affects the optical characteristics. As a method in which an LED module provided with a lens is produced while the distance between the LED element and the lens is adjusted, production has been known in which a lens and a spacer are produced based on the design and in which the spacer and the lens are affixed on a substrate to which an LED element is mounted while the distance between the LED element and the lens is adjusted by the thickness of an adhesive agent (Patent Document 1).

Furthermore, as production for LED modules provided with lenses, a method, in which LED modules provided with a large number of lenses are produced in one lot by using a lens array having a structure in which two or more lenses are arranged and a substrate to which two or more LED elements are mounted in an array, has been known.

### Citation List

### Patent Document

Patent Document 1: JP 2015-180963 A

### Summary of Invention

### Technical Problem

However, when LED modules provided with a large number of lenses are produced in one lot, precise coating with the adhesive agent is extremely difficult. If one distance between the LED element and the lens is out of the range of tolerance, the entire lot is treated as a defective product. It is thus difficult to produce LED modules provided with lenses in a high yield.

An object of the present invention is to provide an optical component array, that is, optical components arranged in an array, that can be directly affixed to a substrate, that allows easy adjustment of the distance between the optical components and the substrate by controlling a pressing force during the affixing, and that can adhere the optical components and the substrate by performing photoirradiation and/or heat treatment.

Another object of the present invention is to provide a production method of the optical component array.

Another object of the present invention is to provide a production method of an arrayed optical module using the optical component array (that is, optical modules arranged in an array).

### Solution to Problem

As a result of diligent research to solve the problems described above, the inventors of the present invention found that use of an optical component array provided with an adhesive layer, the optical component array having a structure in which two or more optical components each having an adhesive layer having heat- or photo-curability and having a particular storage modulus on at least a part of a surface are arranged in an array (i.e. parallel), enables direct adhesion to a substrate, enables easy adjustment of a distance between the optical components and the substrate by controlling pressing force during affixing, enables adhesion of the optical components and the substrate by photoirradiation and/or heat treatment, and enables efficient production of arrayed optical modules in a high yield. The present invention has been completed based on these findings.

That is, the present invention provides an optical component array provided with an adhesive layer, the optical component array having a structure in which two or more optical components are arranged, the optical components each having an adhesive layer having heat- or photo-curability and having a storage modulus at 25°C of 0.05 × 10⁴ to 10000 × 10⁴ Pa on at least a part of a surface.

The present invention also provides the optical component array provided with an adhesive layer described above, where each of the optical components is an optical component formed from a cured product of a curable composition containing an epoxy resin.

The present invention also provides the optical component array provided with an adhesive layer described above, where the epoxy resin is a polyfunctional alicyclic epoxy compound.

The present invention also provides the optical component array provided with an adhesive layer described above, where the epoxy resin is a compound represented by Formula (i) below.

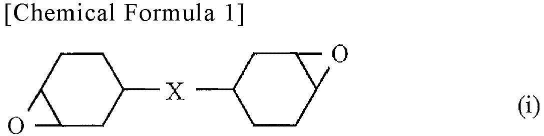

In the formula, X represents a single bond or a linking group.

The present invention also provides the optical component array provided with an adhesive layer described above, where an adhesive layer thickness is 0.05 mm or greater, and the thickness can be adjusted in a range from 20 to 100% by pressing force.

The present invention also provides the optical component array provided with an adhesive layer described above, where the optical component array provided with an adhesive layer has a structure in which the two or more optical components having the adhesive layer on at least a part of the surface are arranged on a support.

The present invention also provides the optical component array provided with an adhesive layer described above, where each of the optical components is a lens.

The present invention also provides the optical component array provided with an adhesive layer described above, where the optical components each having the adhesive layer on at least a part of the surface are each a lens module having a structure in which a lens part, a flange part provided around an entire circumference of the lens part, and a spacer part provided along an outer periphery of the flange part are integrally molded; and also each a lens module provided with an adhesive layer, having an adhesive layer on at least a part of an upper edge face of the spacer part.

The present invention also provides a method for producing an optical component array provided with an adhesive layer to obtain the optical component array provided with an adhesive layer described above, the method including the following steps.
Step 1: subjecting a curable composition containing an epoxy resin to imprint molding to obtain an optical component array having a structure in which two or more optical components are arranged.
Step 2: forming an adhesive layer having a storage modulus at 25°C from 0.05 × 10⁴ to 10000 × 10⁴ Pa on at least a part of a surface of the obtained optical component array.

The present invention also provides a method for producing an arrayed optical module to obtain an arrayed optical module comprising a laminate of an optical component array and a substrate, the method including the following steps.
Step I: laminating the optical component array provided with an adhesive layer described above (a thickness of the adhesive layer: A) on a substrate, the adhesive layer being brought into contact with the substrate.
Step II: adjusting a distance between the optical components and the substrate by pressing the laminate of the optical component array provided with an adhesive layer and the substrate from above to adjust an adhesive layer thickness (B) in a range from 20 to 100% of (A) and by curing the adhesive layer by heat treatment and/or photoirradiation.

The present invention also provides the method for producing an arrayed optical module described above, where the optical component array is a lens array, the substrate is a substrate on which LED elements are mounted, and the arrayed optical module is an LED module provided with arrayed lenses.

### Advantageous Effects of Invention

By the virtue of having the structure described above, the optical component array provided with an adhesive layer according to an embodiment of present invention can be directly affixed to a substrate, can easily adjust the distance between the optical components and the substrate by controlling the pressing force during the affixing, and, by performing photoirradiation and/or heat treatment and curing the adhesive agent thereafter, can efficiently produce arrayed optical modules, in which the distance between the optical components and the substrate is maintained within a particular range, in a high yield.

### Brief Description of Drawings

FIG. 1 is a schematic diagram illustrating a variation on arranged position of an adhesive layer of an optical component provided with an adhesive layer according to embodiments of the present invention. (210) is a diagram illustrating the case where the adhesive layer is provided around the entire circumference of a flange part, and (211) and (212) are diagrams illustrating the cases where the adhesive layer are provided on the four corners of the flange part.
FIG. 2 is a schematic diagram illustrating a method for producing an optical component array according to an embodiment of the present invention.
FIG. 3 is a schematic diagram illustrating an optical component array provided with an adhesive layer according to an embodiment of the present invention (a plan view and a cross-sectional view along the position A-A' of the plan view).
FIG. 4 is a schematic diagram illustrating an optical component array according to another embodiment of the present invention.
FIG. 5 is a schematic diagram illustrating an optical component array provided with an adhesive layer according to another embodiment of the present invention (a plan view and a cross-sectional view along the position A-A' of the plan view).
FIG. 6 is a schematic diagram illustrating a method for producing an arrayed optical module according to an embodiment of the present invention.

### Description of Embodiments

### Optical Component Array Provided with Adhesive Layer

The optical component array provided with an adhesive layer according to an embodiment of the present invention has a structure in which two or more optical components are arranged, the optical components each having an adhesive layer having heat- or photo-curability and having a storage modulus at 25°C from 0.05 × 10⁴ to 10000 × 10⁴ Pa on at least a part of a surface.

### Adhesive Layer

The adhesive layer in the optical component array provided with an adhesive layer according to an embodiment of the present invention has the storage modulus at 25°C from 0.05 × 10⁴ to 10000 × 10⁴ Pa and has a suitable elasticity, and the thickness can be adjusted by pressing force (e.g. adjusted in a range of 20 to 100% of the original thickness). The lower limit of the storage modulus at 25°C is preferably 0.1 × 10⁴ Pa, particularly preferably 0.5 × 10⁴ Pa, and most preferably 1.0 × 10⁴ Pa. Furthermore, the upper limit is preferably 5000 × 10⁴ Pa, particularly preferably 3000 × 10⁴ Pa, most preferably 2000 × 10⁴ Pa, and especially preferably 1000 × 10⁴ Pa.

Furthermore, the adhesive layer is heat- or photo-curable. That is, the adhesive layer has properties of being cured by heat treatment or photoirradiation. The adhesive layer thus contains a compound having a heat- or photo-curable functional group (i.e. heat- or photo-curable compound). More specifically, the adhesive layer is formed from a composition containing a heat- or photo-curable compound (heat- or photo-curable adhesive composition). Hereinafter, the heat- or photo-curable adhesive composition may be simply referred to as "adhesive composition".

The thickness (A) of the adhesive layer is 0.05 mm or greater (e.g. from 0.05 to 1.0 mm, preferably from 0.05 to 0.8 mm, more preferably from 0.2 to 0.8 mm, and particularly preferably from 0.2 to 0.6 mm). Since the adhesive layer has the storage modulus at 25°C within the range described above, the thickness can be adjusted by pressing force (e.g. vertically pressing a face with a force of 5 to 100 N/m²) in a range, for example, from 20 to 100% (preferably from 20 to 90%, particularly preferably from 20 to 80%, and most preferably from 20 to 60%).

Furthermore, the adhesive layer can be cured by heat treatment or photoirradiation. The heat treatment and the photoirradiation can be performed according to the conditions described below.

Examples of the adhesive composition include acrylic resin adhesive compositions, epoxy resin adhesive compositions, silicone-based resin adhesive compositions, and the like. One type alone or two or more types thereof in combination can be used.

### Acrylic Resin Adhesive Composition

The acrylic resin adhesive composition is an adhesive composition at least containing an acrylic resin having a heat- or photo-curable functional group and preferably further contains a crosslinking agent (e.g. an epoxy-based crosslinking agent or an isocyanate-based crosslinking agent) or a polymerization initiator.

The acrylic resin having a heat- or photo-curable functional group is a resin having a heat- or photo-curable functional group, and the constituent monomer thereof is not particularly limited as long as an acrylic monomer is contained, and examples of the acrylic resin include polymers obtained by polymerizing one or two or more types of alkyl (meth)acrylates as main monomers and one or two or more types of monomers that have a heat- or photo-curable functional group and that are polymerizable with the main monomer.

Examples of the main monomer include alkyl (meth)acrylates, such as n-butyl (meth)acrylate, isobutyl (meth)acrylate, s-butyl (meth)acrylate, t-butyl (meth)acrylate, pentyl (meth)acrylate, isopentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. Note that, in the present specification, "(meth)acryl" means "acryl" and/or "methacryl".

Examples of the monomer that has a heat- or photo-curable functional group and that is polymerizable with the main monomer (hereinafter, also referred to as "auxiliary monomer") include carboxyl group-containing monomers, such as (meth)acrylic acid, itaconic acid, maleic acid, fumaric acid, crotonic acid, isocrotonic acid, maleic anhydride, and itaconic anhydride; epoxy group-containing monomers, such as allyl glycidyl ether, glycidyl (meth)acrylate, and 3,4-epoxycyclohexylmethyl(meth)acrylate; silyl group-containing monomers, such as γ-trimethoxysilane(meth)acrylate and γ-triethoxysilane(meth)acrylate; amide group-containing monomers, such as (meth)acrylamide, N-methyl(meth)acrylamide, N-methylol(meth)acrylamide, and N-butoxymethyl(meth)acrylamide; aldehyde group-containing monomers, such as acrolein and methacrolein; and the like.

Furthermore, the acrylic resin may contain another monomer, besides the main monomer and the auxiliary monomer, and is not particularly limited. Examples thereof include styrene-based monomers, such as styrene, o-methylstyrene, m-methylstyrene, p-methylstyrene, 2,4-dimethylstyrene, 2,5-dimethylstyrene, ethylstyrene, trimethylstyrene, pentamethylstyrene, diethylstyrene, isopropyl styrene, butylstyrene (3-t-butylstyrene, 4-t-butylstyrene, and the like); and the like.

### Epoxy Resin Adhesive Composition

The epoxy resin adhesive composition is an adhesive composition containing at least an epoxy resin as a curable compound (preferably a cationic curable compound). In addition, the epoxy resin adhesive composition preferably contains a polymerization initiator (e.g. photocationic polymerization initiator described below).

The epoxy resin is not particularly limited, and a known or commonly used compound having one or more epoxy groups (oxirane ring) in a molecule can be used. Examples thereof include alicyclic epoxy resins, aromatic epoxy resins, aliphatic epoxy resins, and the like.

Examples of the alicyclic epoxy resin include glycidyl ethers of alicyclic alcohols (in particular, alicyclic polyhydric alcohols). More specifically, examples thereof include hydrogenated bisphenol A epoxy compounds, hydrogenated bisphenol F epoxy compounds, hydrogenated biphenol epoxy compounds, hydrogenated phenol novolac epoxy compounds, hydrogenated cresol novolac epoxy compounds, and the like.

Examples of the aromatic epoxy resin include bisphenol A epoxy compounds, bisphenol F epoxy compounds, biphenol epoxy compounds, phenol novolac epoxy compounds, cresol novolac epoxy compounds, and the like.

Examples of the aliphatic epoxy resin include glycidyl ethers of monohydric or polyhydric alcohols having no cyclic structure; glycidyl esters of monovalent or polyvalent carboxylic acids (e.g. acetic acid, propionic acid, butyric acid, stearic acid, adipic acid, sebacic acid, maleic acid, itaconic acid, and the like); epoxidized materials of fats and oils having a double bond, such as epoxidized linseed oil, epoxidized soybean oil, and epoxidized castor oil; epoxidized materials of polyolefins (including polyalkadienes), such as epoxidized polybutadiene; and the like.

### Silicone-based Resin Adhesive Composition

The silicone-based resin adhesive composition at least contains a silicone-based resin having addition polymerizability, dehydration condensability, or peroxide curability. Additionally, an addition polymerization catalyst, a dehydration condensation agent, a crosslinking agent, and the like may be contained. Furthermore, the silicone-based resin adhesive composition may be a one-part or two-part type.

As the silicone-based resin adhesive composition, for example, commercially available products, such as KE series, KER series, KR series, and X series, available from Shin-Etsu Chemical Co., Ltd.; or TN series, TSE series, TSR series, ECS series, YR series, PSA series, and XR series, available from Momentive Performance Materials Japan LLC, can be used without particular limitation.

### Optical Component Array

The optical component array according to an embodiment of the present invention has a structure in which two or more optical components are arranged. Examples of the optical component include lenses, such as microlens and Fresnel lens. In an embodiment of the present invention, a lens module having a structure in which a lens part, such as a microlens or a Fresnel lens, and a flange part provided around an entire circumference of the lens part are integrally molded is preferred; and a lens module having a structure in which a lens part, such as a microlens or a Fresnel lens, a flange part provided around an entire circumference of the lens part, and a spacer part provided along an outer periphery of the flange part are integrally molded is more preferred.

The optical component array has a structure in which two or more (e.g. 10 or more, preferably 20 or more, particularly preferably 30 or more, and most preferably 50 or more; note that the upper limit is, for example, 5000 and preferably 2000) optical components are arranged, may have a structure in which two or more of the optical components are connected each other, or may have a structure in which diced two or more of the optical components are arranged on a support (e.g. tape or film provided with an adhesive layer, such as a dicing tape).

In the case where the optical component is a lens for example, regarding the size of the optical component, the diameter (or the maximum value of diameter) is approximately from 0.5 to 10 mm, and the thickness (or the maximum value of thickness) is approximately from 0.1 to 2.0 mm.

The optical component is preferably an optical component formed from a cured product of a curable composition (preferably a photocurable composition) containing an epoxy resin, from the perspectives of excellent transparency, heat resistance, and weather resistance.

The optical component array provided with an adhesive layer according to an embodiment of the present invention can be produced by the following steps, for example.

Step 1: subjecting a curable composition containing an epoxy resin to imprint molding to obtain an optical component array having a structure in which two or more optical components are arranged.

Step 2: forming an adhesive layer having a storage modulus at 25°C from 0.05 × 10⁴ to 10000 × 10⁴ Pa on at least a part of a surface of the obtained optical component array.

### Curable Composition Containing Epoxy Resin

The curable composition containing an epoxy resin (hereinafter, also simply referred to as "curable composition") is a composition containing at least an epoxy resin as a curable compound (preferably a cationic curable compound). As the epoxy resin, a known or commonly used compound having one or more epoxy groups (oxirane ring) in a molecule can be used. Examples thereof include alicyclic epoxy compounds, aromatic epoxy compounds, aliphatic epoxy compounds, and the like. In an embodiment of the present invention, among these, from the perspective of a cured product having excellent heat resistance and transparency can be formed, a polyfunctional alicyclic epoxy compound having an alicyclic structure and having two or more epoxy groups as functional groups in a molecule is preferred.

### Specific examples of the polyfunctional alicyclic epoxy compound include

(i) a compound having an epoxy group formed from two adjacent carbon atoms and an oxygen atom constituting an alicycle (alicyclic epoxy group);
(ii) a compound having an epoxy group directly bonded to an alicycle through a single bond;
(iii) a compound having an alicycle and a glycidyl group;
and the like.

Examples of (i) the compound having an alicyclic epoxy group described above include compounds represented by Formula (i) below. 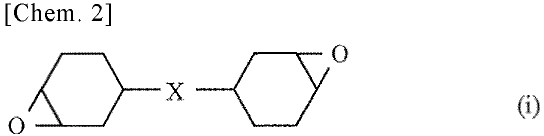 In Formula (i) above, X represents a single bond or a linking group (a divalent group having one or more atoms). Examples of the linking group include divalent hydrocarbon groups, alkenylene groups in which some or all of the carbon-carbon double bonds are epoxidized, carbonyl groups, ether bonds, ester bonds, carbonate groups, amide groups, and groups in which a plurality thereof are linked. Note that a substituent, such as an alkyl group, may be bonded to the one or more carbon atoms constituting the cyclohexane rings (cyclohexene oxide groups) in Formula (i).

Examples of the divalent hydrocarbon group include straight-chain or branched alkylene groups having from 1 to 18 carbons, divalent alicyclic hydrocarbon groups, and the like. Examples of the straight-chain or branched alkylene group having from 1 to 18 carbons include a methylene group, a methyl methylene group, a dimethyl methylene group, an ethylene group, a propylene group, a trimethylene group, and the like. Examples of the divalent alicyclic hydrocarbon group include cycloalkylene groups (including cycloalkylidene groups), such as a 1,2-cyclopentylene group, a 1,3-cyclopentylene group, a cyclopentylidene group, a 1,2-cyclohexylene group, a 1,3-cyclohexylene group, a 1,4-cyclohexylene group, and a cyclohexylidene group, and the like.

Examples of the alkenylene group in the alkenylene group in which some or all of the carbon-carbon double bonds are epoxidized (which may be referred to as "epoxidized alkenylene group") include straight-chain or branched alkenylene groups having from 2 to 8 carbons, such as a vinylene group, a propenylene group, a 1-butenylene group, a 2-butenylene group, a butadienylene group, a pentenylene group, a hexenylene group, a heptenylene group, and an octenylene group, and the like. In particular, the epoxidized alkenylene group is preferably an alkenylene group in which all of the carbon-carbon double bonds are epoxidized; and more preferably an alkenylene group having from 2 to 4 carbons in which all of the carbon-carbon double bonds are epoxidized.

As the linking group of X described above, a linking group containing an oxygen atom is particularly preferred, and specific examples thereof include -CO-, -O-CO-O-, -COO-, -O-, -CONH-, an epoxidized alkenylene group; a group in which a plurality of these groups are linked; a group in which one or two or more of these groups and one or two or more of the divalent hydrocarbon groups described above are linked; and the like.

Representative examples of the compound represented by Formula (i) above include (3,4,3',4'-diepoxy)bicyclohexyl, bis(3,4-epoxycyclohexylmethyl)ether, 1,2-epoxy-1,2-bis(3,4-epoxycyclohexan-1-yl)ethane, 2,2-bis(3,4-epoxycyclohexan-1-yl)propane, 1,2-bis(3,4-epoxycyclohexan-1-yl)ethane, compounds represented by Formulas (i-1) to (i-10) below, and the like. L in Formula (i-5) below is an alkylene group having from 1 to 8 carbons, and among these, a straight-chain or branched alkylene group having from 1 to 3 carbons, such as a methylene group, an ethylene group, a propylene group, or an isopropylene group, is preferred. In Formulas (i-5), (i-7), (i-9), and (i-10) below, n¹ to n⁸ each represent an integer from 1 to 30.

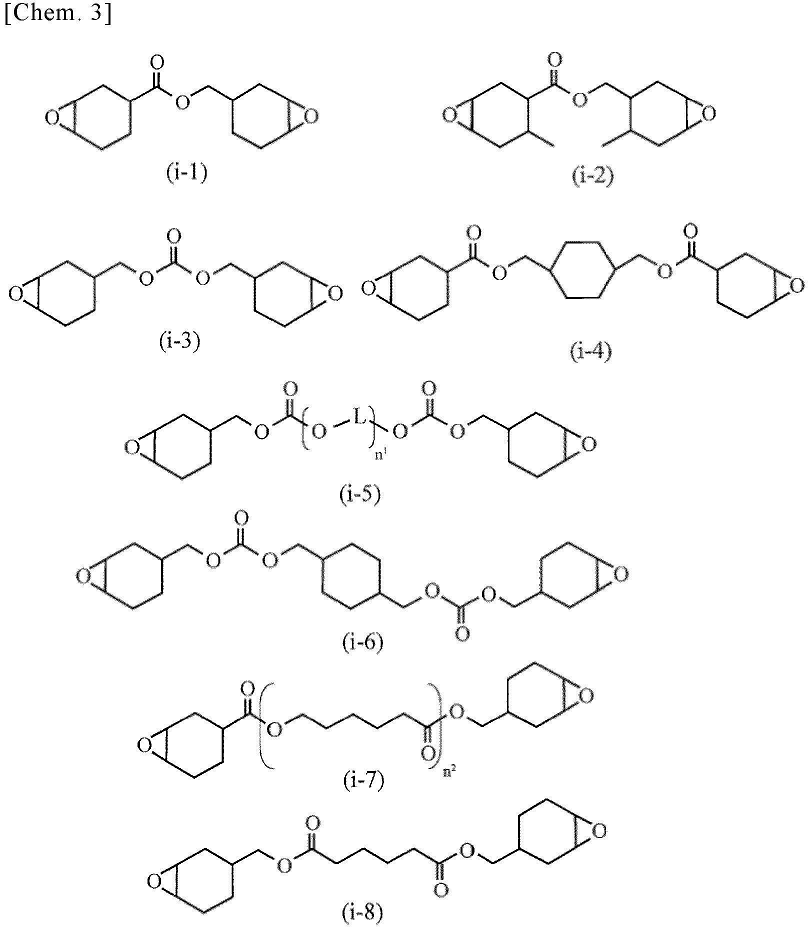

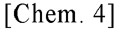

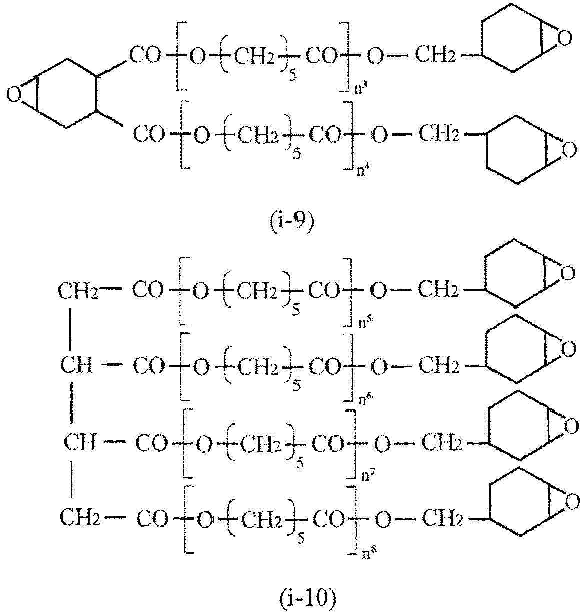

(i) The compound having an alicyclic epoxy group described above includes epoxy-modified siloxanes.

Examples of the epoxy-modified siloxane include chain-like or cyclic polyorganosiloxanes each having a structural unit represented by Formula (i') below. 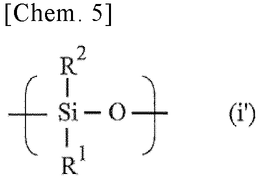 In Formula (i') above, R¹ represents a substituent containing an epoxy group represented by Formula (1a) or (1b) below, and R² represents an alkyl group or an alkoxy group. 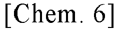 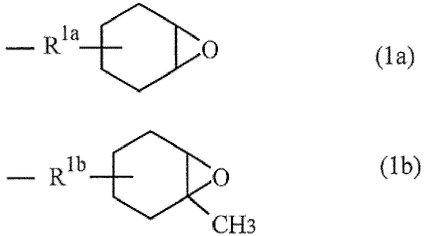 In the formula, R^{1a} and R^{1b} may be the same or different and each represent a straight-chain or branched alkylene group, and examples thereof include straight-chain or branched alkylene groups having from 1 to 10 carbons, such as a methylene group, a methyl methylene group, a dimethyl methylene group, an ethylene group, a propylene group, a trimethylene group, a tetramethylene group, a pentamethylene group, a hexamethylene group, and a decamethylene group.

The epoxy equivalent weight (in accordance with JIS K 7236) of the epoxy-modified siloxane is, for example, from 100 to 400 and preferably from 150 to 300.

As the epoxy-modified siloxane, for example, commercially available products, such as epoxy-modified cyclic polyorganosiloxane represented by Formula (i'-1) below (trade name "X-40-2670", available from Shin-Etsu Chemical Co., Ltd.), can be used.

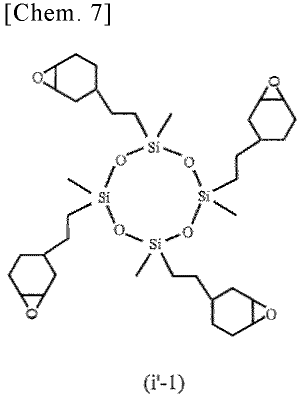

Examples of (ii) the compound having an epoxy group directly bonded to an alicycle through a single bond include compounds represented by Formula (ii) below and the like. 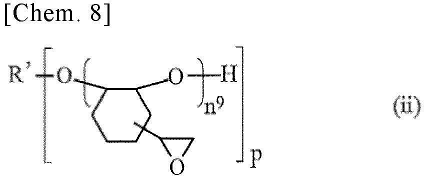 In Formula (ii), R' is a group resulting from elimination of p hydroxy groups (-OH) from a structural formula of a p-valent alcohol (p-valent organic group), where p and n⁹ each represent a natural number. Examples of the p-valent alcohol [R'-(OH)ₚ] include polyhydric alcohols (alcohols having from 1 to 15 carbons and the like), such as 2,2-bis(hydroxymethyl)-1-butanol; and the like. p is preferably from 1 to 6, and n⁹ is preferably from 1 to 30. When p is 2 or greater, n⁹ in each group in parentheses (in the outer parentheses) may be the same or different. Examples of the compound represented by Formula (ii) specifically include 1,2-epoxy-4-(2-oxiranyl)cyclohexane adduct of 2,2-bis(hydroxymethyl)-1-butanol (for example, such as the trade name "EHPE3150" (available from Daicel Corporation)).

Examples of (iii) the compound having an alicycle and a glycidyl group described above include hydrogenated aromatic glycidyl ether-based epoxy compounds, such as compounds obtained by subjecting bisphenol A epoxy compound to hydrogenation (hydrogenated bisphenol A epoxy compound), compounds obtained by subjecting bisphenol F epoxy compound to hydrogenation (hydrogenated bisphenol F epoxy compound), hydrogenated biphenol epoxy compounds, hydrogenated phenol novolac epoxy compounds, hydrogenated cresol novolac epoxy compounds, hydrogenated cresol novolac epoxy compounds of bisphenol A, hydrogenated naphthalene epoxy compounds, and hydrogenated epoxy compounds of epoxy compounds obtained from trisphenol methane, and the like.

As the polyfunctional alicyclic epoxy compound, among these, from the perspective of obtaining a cured product having a high surface hardness and excellent transparency, (i) the compound having an alicyclic epoxy group is preferred, and a compound represented by Formula (i) above (especially, (3,4,3',4'-diepoxy)bicyclohexyl) is particularly preferred.

The curable composition may also contain another curable compound besides the epoxy resin as the curable compound and, for example, may contain a cationic curable compound, such as an oxetane compound or a vinyl ether compound.

The proportion of the epoxy resin in the total amount (100 wt.%) of the curable compound contained in the curable composition is, for example, 50 wt.% or greater, preferably 60 wt.% or greater, particularly preferably 70 wt.% or greater, and most preferably 80 wt.% or greater. Note that the upper limit is, for example, 100 wt.% and preferably 90 wt.%.

The proportion of (i) the compound having an alicyclic epoxy group in the total amount (100 wt.%) of the curable compound contained in the curable composition is, for example, 20 wt.% or greater, preferably 30 wt.% or greater, and particularly preferably 40 wt.% or greater. Note that the upper limit is, for example, 70 wt.% and preferably 60 wt.%.

The proportion of the compound represented by Formula (i) in the total amount (100 wt.%) of the curable compound contained in the curable composition is, for example, 10 wt.% or greater, preferably 15 wt.% or greater, and particularly preferably 20 wt.% or greater. Note that the upper limit is, for example, 50 wt.% and preferably 40 wt.%.

The curable composition preferably contains a photopolymerization initiator together with the curable compound and particularly preferably contains a photocationic polymerization initiator. The photocationic polymerization initiator is a compound that initiates curing reaction of the curable compound (especially, cationic curable compound) contained in the curable composition by generating an acid when irradiated with light and is formed from a cation moiety that absorbs light and an anion moiety that serves as a source of generation of the acid.

Examples of the photocationic polymerization initiator include diazonium salt-based compounds, iodonium salt-based compounds, sulfonium salt-based compounds, phosphonium salt-based compounds, selenium salt-based compounds, oxonium salt-based compounds, ammonium salt-based compounds, bromine salt-based compounds, and the like.

In the present invention, among these, use of a sulfonium salt-based compound is preferred because a cured product having excellent curability can be formed. Examples of the cation moiety of the sulfonium salt-based compound include arylsulfonium ions (especially, triarylsulfonium ions), such as a (4-hydroxyphenyl)methylbenzylsulfonium ion, a triphenyl sulfonium ion, a diphenyl[4-(phenylthio)phenyl]sulfonium ion, a 4-(4-biphenylthio)phenyl-4-biphenylylphenylsulfonium ion, and a tri-p-tolylsulfonium ion.

Examples of the anion moiety of the photocationic polymerization initiator include [(Y)ₛB(Phf)₄₋ₛ]⁻ (in the formula, Y represents a phenyl group or a biphenylyl group, Phf represents a phenyl group in which at least one hydrogen atom is replaced with at least one type selected from the group consisting of a perfluoroalkyl group, a perfluoroalkoxy group, and a halogen atom, and s is an integer of 0 to 3.); BF₄⁻, [(Rf)ₜPF₆₋ₜ]⁻ (in the formula, Rf represents an alkyl group in which 80% or more of hydrogen atoms are replaced with fluorine atoms, and t represents an integer of 0 to 5.); AsF₆⁻; SbF₆⁻; SbF₅OH⁻; and the like.

As the photocationic polymerization initiator, for example, (4-hydroxyphenyl)methylbenzylsulfonium tetrakis(pentafluorophenyl)borate; 4-(4-biphenylylthio)phenyl-4-biphenylylphenylsulfonium tetrakis(pentafluorophenyl)borate; 4-(phenylthio)phenyldiphenylsulfonium phenyltris(pentafluorophenyl)borate; [4-(4-biphenylylthio)phenyl]-4-biphenylylphenylsulfonium phenyltris(pentafluorophenyl)borate; diphenyl[4-(phenylthio)phenyl]sulfonium tris(pentafluoroethyl)trifluorophosphate; diphenyl[4-(phenylthio)phenyl]sulfonium tetrakis(pentafluorophenyl)borate; diphenyl[4-(phenylthio)phenyl]sulfonium hexafluorophosphate; 4-(4-biphenylylthio)phenyl-4-biphenylylphenylsulfonium tris(pentafluoroethyl)trifluorophosphate; bis[4-(diphenylsulfonio)phenyl]sulfide phenyltris(pentafluorophenyl)borate; [4-(2-thioxanthonylthio)phenyl]phenyl-2-thioxanthonylsulfonium phenyltris(pentafluorophenyl)borate; 4-(phenylthio)phenyldiphenylsulfonium hexafluoroantimonate; and commercially available products, such as trade names "Cyracure UVI-6970", "Cyracure UVI-6974", "Cyracure UVI-6990", and "Cyracure UVI-950" (these are available from Union Carbide Corporation in the US); "Irgacure 250", "Irgacure 261", and "Irgacure 264" (these are available from BASF); "CG-24-61" (available from Ciba-Geigy Ltd.); "Optomer SP-150", "Optomer SP-151", "Optomer SP-170", and "Optomer SP-171" (these are available from Adeka Corporation); "DAICAT II" (available from Daicel Corporation); "UVAC 1590" and "UVAC 1591" (these are available from Daicel-Cytec Co., Ltd.); "CI-2064", "CI-2639", "CI-2624", "CI-2481", "CI-2734", "CI-2855", "CI-2823", "CI-2758", and "CIT-1682" (these are available from Nippon Soda Co., Ltd.); "PI-2074" (available from Rhodia; tetrakis(pentafluorophenyl)borate tricumyliodonium salt); "FFC 509" (available from 3M); "BBI-102", "BBI-101", "BBI-103", "MPI-103", "TPS-103", "MDS-103", "DTS-103", "NAT-103", and "NDS-103" (these are available from Midori Kagaku Co., Ltd.); "CD-1010", "CD-1011", and "CD-1012" (these are available from Sartomer in the US); and "CPI-100P" and "CPI-101A" (these are available from San-Apro Ltd.), can be used.

The content of the photopolymerization initiator is, for example, in a range of 0.1 to 5.0 parts by weight per 100 parts by weight of the curable compound (especially, cationic curable compound) contained in the curable composition. The content of the photopolymerization initiator of lower than the range described above may cause failure in the curing. On the other hand, the content of the photopolymerization initiator of greater than the range described above tends to cause coloration of the cured product.

The curable composition can be produced by mixing the curable compound and the photopolymerization initiator and, optionally, other component(s) (e.g. solvents, antioxidants, surface conditioners, photosensitizers, defoaming agents, leveling agents, coupling agents, surfactants, flame retardants, ultraviolet absorbers, coloring agents, and the like). The compounded amount of the other component(s) is, for example, 20 wt.% or less, preferably 10 wt.% or less, and particularly preferably 5 wt.% or less, relative to the total amount of the curable composition.

As the curable composition, for example, commercially available products, such as trade name "CELVENUS OUH106" (available from Daicel Corporation), can be used.

### Step 1

Step 1 is a step of subjecting a curable composition containing an epoxy resin to imprint molding to obtain an optical component array having a structure in which two or more optical components are arranged. In the imprint molding, the optical component array having a structure in which two or more optical components are arranged can be obtained by, for example, applying a curable composition containing an epoxy resin onto a mold having two or more inverted concavo-convex shapes of the optical components (e.g. silicone mold), curing the composition by photoirradiation to obtain a molded product in which two or more optical components are connected, and optionally dicing the molded product by a method, such as dicing.

The photocuring of the curable composition can be performed by being irradiated with an active energy ray, such as ultraviolet ray or electron beam. As the light source during the ultraviolet ray irradiation, a high-pressure mercury-vapor lamp, an ultrahigh-pressure mercury-vapor lamp, a carbon-arc lamp, a xenon lamp, a metal halide lamp, or the like is used. The irradiation time varies depending on the type of the light source, the distance between the light source and the coated surface, and other conditions; however, the irradiation time is at most several tens of seconds. The illuminance is approximately from 5 to 200 mW/cm². For the photoirradiation conditions, in a case where ultraviolet ray is irradiated, the accumulated light amount is preferably adjusted to, for example, 5000 mJ/cm² or less (e.g. 2500 to 5000 mJ/cm²). After the irradiation with the active energy ray, as necessary, heating (post curing) may be performed to promote the curing.

### Step 2

Step 2 is a step of forming an adhesive layer having a storage modulus at 25°C from 0.05 × 10⁴ to 10000 × 10⁴ Pa on at least a part of a surface of the obtained optical component array.

The adhesive layer having the storage modulus described above can be formed by being coated with a heat- or photo-curable adhesive composition in which the storage modulus at 25°C is adjusted to from 0.05 × 10⁴ to 10000 × 10⁴ Pa or a solvent diluted product, and then optionally drying. Note that the adjustment of the storage modulus of the adhesive composition can be performed by, for example, partially proceeding the curing reaction by heat treatment or photoirradiation (i.e. performing semi-curing). In addition, formation may be performed by applying the adhesive composition having the storage modulus at 25°C of less than 0.05 × 10⁴ Pa, drying, and then partially proceeding the curing reaction of the adhesive composition by heat treatment or photoirradiation (i.e. performing semi-curing) to adjust the storage modulus at 25°C in the range from 0.05 × 10⁴ to 10000 × 10⁴ Pa.

The adhesive layer is preferably formed by the semi-cured product (= stage B cured product) of the adhesive composition.

As for applying the adhesive composition, for example, a dispenser discharge method, a squeegee method, a spin coat method, a roll coat method, a dipping method, a spraying method, a curtain flow coating method, a screen printing method, an offset printing method, a gravure coating method, or the like can be employed.

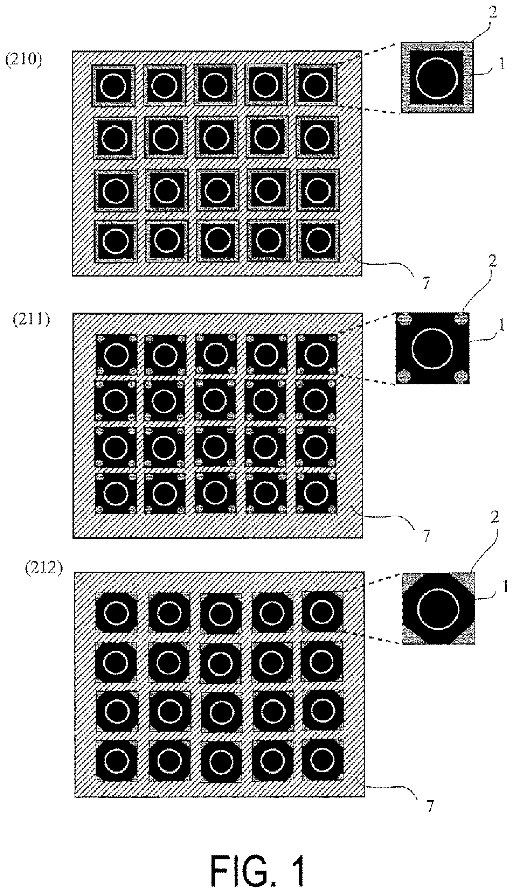

In the optical component, the part where the adhesive layer is provided may be at least a part of the surface of the optical component, and for example, in the case where the optical component is a lens module having a structure in which a lens part and a flange part provided around an entire circumference of the lens part are integrally molded, the part where the adhesive layer is provided may be at least a part of the flange part. In particular, at least the four corners of the flange part are preferably provided with the adhesive layers (see FIG. 1). Furthermore, in the case where the optical component is a lens module having a structure in which a lens part, a flange part provided around an entire circumference of the lens part, and a spacer part provided along an outer periphery of the flange part are integrally molded, the part where the adhesive layer is provided may be at least a part of an upper edge face of the spacer part. In particular, at least the four corners of the upper edge face of the spacer part are preferably provided with the adhesive layers.

Therefore, as the optical component array provided with an adhesive layer according to an embodiment of the present invention, in particular, a lens module having a structure in which a lens part and a flange part provided around an entire circumference of the lens part are integrally molded, the lens module provided with an adhesive layer, having an adhesive layer on at least a part of the flange part, is preferred.

In particular, as the optical component array provided with an adhesive layer according to an embodiment of the present invention, a lens module having a structure in which a lens part, a flange part provided around an entire circumference of the lens part, and a spacer part provided along an outer periphery of the flange part are integrally molded, the lens module provided with an adhesive layer, having an adhesive layer on at least a part of the upper edge face of the spacer part, is preferred.

In the case where the adhesive composition is subjected to heat treatment to be semi-cured, for example, heating at a temperature of 100 to 200°C for approximately for 0.5 to 2 hours is preferred.

In the case where the adhesive composition is subjected to photoirradiation to be semi-cured, as the light used in the photoirradiation (active energy ray), any of an infrared ray, a visible ray, an ultraviolet ray, an X-ray, an electron beam, an α-ray, a β-ray, or a γ-ray can be used. In an embodiment of the present invention, among these, an ultraviolet ray is preferred from the perspective of excellent handling. For example, a UV-LED (wavelength: 350 to 450 nm), a high-pressure mercury lamp, an ultra high-pressure mercury lamp, a xenon lamp, a carbon arc, a metal halide lamp, sunlight, a laser, or the like can be used for the irradiation with ultraviolet ray.

### Method for Producing Arrayed Optical Module

The arrayed optical module according to an embodiment of the present invention is a module having a laminate of an optical component array and a substrate and can be produced by the following steps.
Step I: laminating the optical component array provided with an adhesive layer described above (a thickness of the adhesive layer: A) on a substrate, the adhesive layer being brought into contact with the substrate.
Step II: adjusting a distance between the optical components and the substrate by pressing the laminate of the optical component array provided with an adhesive layer and the substrate from above to adjust an adhesive layer thickness (B) in a range from 20 to 100% of (A) and by curing the adhesive layer by heat treatment and/or photoirradiation.

As the optical component array provided with an adhesive layer in Step I, for example, an optical component array provided with an adhesive layer obtained by the method for producing an optical component array provided with an adhesive layer described above can be used. Furthermore, as the substrate, for example, silicon carbide, gallium nitride, sapphire, silicon, germanium, gallium-arsenic, or the like can be used. Furthermore, one or two or more light-emitting elements, such as LED elements, may be mounted. In an embodiment of the present invention, in particular, two or more (e.g., 10 or more, preferably 20 or more, particularly preferably 30 or more, and most preferably 50 or more; note that the upper limit is, for example, 5000 and preferably 2000) of the light-emitting elements, such as LED elements, are preferably arranged and mounted. Especially, the light-emitting elements are preferably arranged corresponding to the arrangement of the optical components in the laminated optical component array and mounted.

Step II described above is a step of pressing the laminate obtained by Step I described above from above, adjusting the adhesive layer thickness, and curing the adhesive layer. The pressing force is, for example, 100 N/m² or less, preferably from 5 to 100 N/m², and more preferably from 5 to 75 N/m². Pressing with the pressing force within the range described above enables adjustment of the adhesive layer thickness (B) in a range, for example, from 20 to 100% (preferably from 20 to 90%, particularly preferably from 20 to 60%, and most preferably from 20 to 60%) of the thickness (A). By performing Step II described above, the distance between the optical components and the substrate can be adjusted in the range described above, and an arrayed optical module in which the distance between the optical components and the substrate is adjusted can be obtained.

According to the method for producing an arrayed optical module according to an embodiment of the present invention, in the case where the optical component is a lens, modules provided with arrayed lenses can be obtained precisely, efficiently, and in a high yield by Steps I and II described above. In the case where a substrate on which LED elements are mounted is used as a substrate, LED modules provided with arrayed lenses can be obtained precisely, efficiently, and in a high yield by Steps I and II described above.

Furthermore, in the case where two or more optical components constituting the optical component array provided with an adhesive layer are connected to each other, the arrayed optical module obtained by Step II described above can be optionally diced by dicing treatment or the like.

### Examples

Hereinafter, the present invention will be described more specifically with reference to examples, however, the present invention is not limited by these examples.

### Example 1

### Production of Lens Array

In concave portions of a transparent bottom mold having a plurality of the concave portions, a curable composition (trade name "CELVENUS OUH 106", containing a cationic curable compound and a photocationic polymerization initiator, where 85 wt.% of the total amount of the cationic curable compound is an epoxy resin and where 30 wt.% of the total amount of the cationic curable compound is (3,4,3',4'-diepoxy)bicyclohexyl as the epoxy resin; available from Daicel Corporation) was charged, and the mold was closed by covering the bottom mold with a transparent upper mold. The curable composition was subjected to photoirradiation (wavelength: 365 nm; irradiation intensity: 50 to 100 mW/cm²; integrated light quantity: 2500 to 5000 mJ/cm²) by using a UV-LED (trade name "ZUV-C20H", available from OMRON Corporation) and then released from the mold to obtain a molded product.

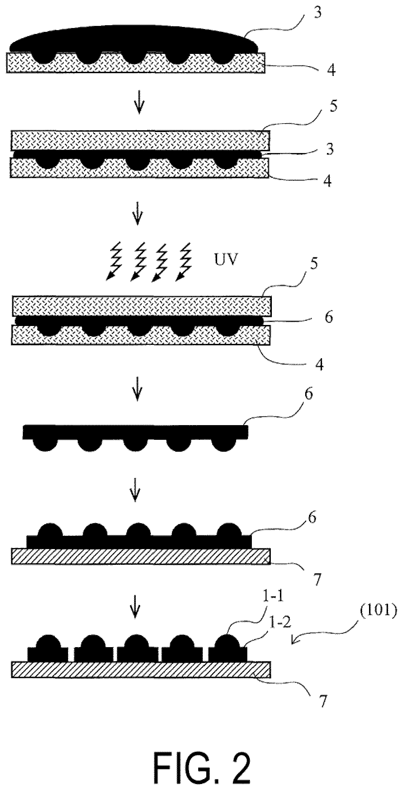

The obtained molded product was fixed on a dicing tape as a support and subjected to blade dicing, then washing, and drying to obtain a lens array in which a plurality of lenses are arranged on a support (101) (FIG. 2).

### Production of Lens Array Provided with Adhesive Layer

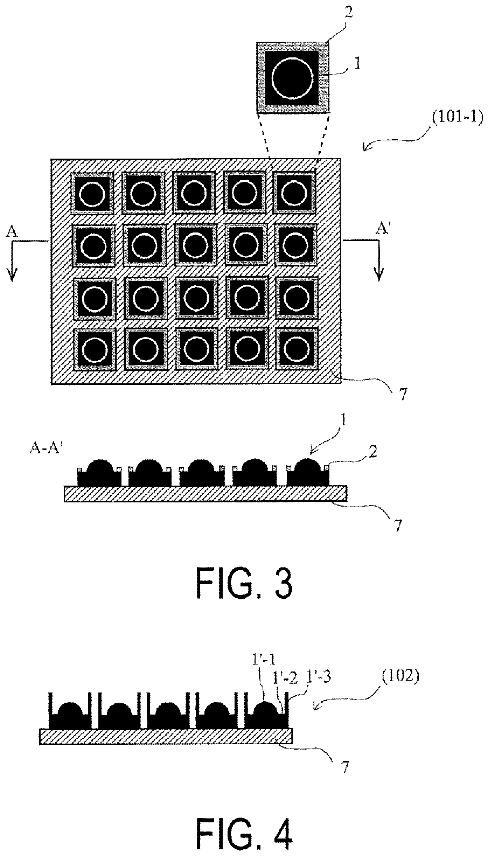

To the obtained lens array (101), an adhesive agent (1) having the storage modulus at 25°C of 2.0 × 10⁴ Pa was applied by using a dispenser, and the height of the applied adhesive agent (1) was 0.1 mm. A lens array provided with an adhesive layer (101-1) was thus obtained. The adhesive agent was applied onto a flange part provided around an entire circumference of the lens part of the lens array (101) in a shape illustrated in FIG. 3. The lens array provided with the adhesive layer (101-1) was left at 25°C for 3 days after the production (i.e. after the adhesive agent was applied), the shape of the adhesive layer was not deformed, and the height was maintained at 0.1 mm.

### Production of Module Provided with Arrayed Lenses

The adhesive layer face of the lens array provided with the adhesive layer (101-1) was affixed to a substrate and pressed from above by the force of 10 N/cm², and then the thickness of the adhesive layer became 0.05 mm. In this condition, the adhesive layer was irradiated with UV and completely cured, and a module provided with arrayed lenses was thus obtained.

### Example 2

### Production of Lens Array / Production of Lens Array Provided with Adhesive Layer

A lens array provided with an adhesive layer (101-2) was obtained in the same manner as in Example 1 except for using an adhesive agent (2) having the storage modulus at 25°C of 850 × 10⁴ Pa in place of the adhesive agent (1). The lens array provided with the adhesive layer (101-2) was left at 25°C for 3 days after the production (i.e. after the adhesive agent was coated), the shape of the adhesive layer was not deformed, and the height of the adhesive layer was maintained at 0.1 mm.

### Production of Module Provided with Arrayed Lenses

The adhesive layer face of the lens array provided with the adhesive layer (101-2) was affixed to a substrate and pressed from above in the same manner as in Example 1, and then the thickness of the adhesive layer became 0.07 mm. In this condition, the adhesive layer was irradiated with UV and completely cured, and a module provided with arrayed lenses was thus obtained.

### Comparative Example 1

### Production of Lens Array / Production of Lens Array Provided with Adhesive Layer

A lens array provided with an adhesive layer (101-3) was obtained in the same manner as in Example 1 except for using an adhesive agent (3) having the storage modulus at 25°C of 0.026 × 10⁴ Pa in place of the adhesive agent (1). In the lens array provided with the adhesive layer (101-3), the shape of the adhesive layer was deformed as time passed, and the height of 0.1 mm was not maintained.

### Comparative Example 2

### Production of Lens Array / Production of Lens Array Provided with Adhesive Layer

A lens array provided with an adhesive layer (101-4) was obtained in the same manner as in Example 1 except for using an adhesive agent (4) having the storage modulus at 25°C of 14000 × 10⁴ Pa in place of the adhesive agent (1). The lens array provided with the adhesive layer (101-4) was left at 25°C for 3 days after the production (i.e. after the adhesive agent was applied), the shape of the adhesive layer was not deformed, and the height was maintained at 0.1 mm.

### Production of Module Provided with Arrayed Lenses

The adhesive layer face of the lens array provided with the adhesive layer (101-4) was affixed to a substrate and pressed from above in the same manner as in Example 1; however, the thickness of the adhesive layer was 0.10 mm, and the pressing failed to deform the adhesive layer and failed to adjust the distance between the lenses and the substrate.

### Example 3

### Production of Lens Array

A lens array (102) was obtained in the same manner as in Example 1 except for using a bottom mold having a different concave portion shape (FIG. 4).

### Production of Lens Array Provided with Adhesive Layer

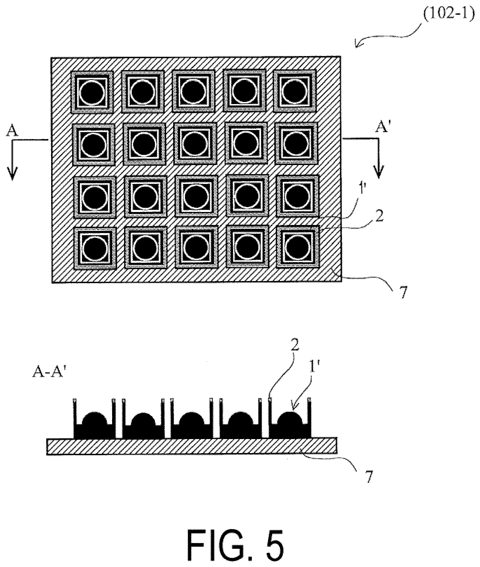

A lens array provided with the adhesive layer (102-1) was obtained in the same manner as in Example 1 except for using a lens array (102) in place of the lens array (101). The adhesive agent was applied onto an upper edge face of a spacer part provided along an outer periphery of a flange part provided around an entire circumference of the lens part of the lens array (102) in a shape illustrated in FIG. 5. The lens array provided with the adhesive layer (102-1) was left at 25°C for 3 days after the production (i.e. after the adhesive agent was applied), the shape of the adhesive layer was not deformed, and the height was maintained at 0.1 mm.

### Production of Module Provided with Arrayed Lenses

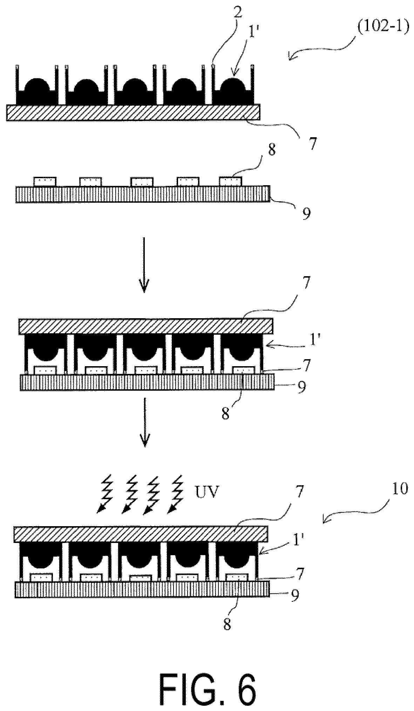

The adhesive layer face of the lens array provided with the adhesive layer (102-1) was affixed to a substrate and pressed from above in the same manner as in Example 1, and then the thickness of the adhesive layer became 0.06 mm. In this condition, the adhesive layer was irradiated with UV and completely cured, and a module provided with arrayed lenses was thus obtained (FIG. 6).

### Reference Signs List

1, 1' Lens
1-1, 1'-1 Lens part
1-2, 1'-2 Flange part
1'-3 Spacer part
101, 102 Lens array
101-1, 102-1, 210, 211, 212 Lens array provided with adhesive layer
2 Adhesive layer
3 Curable composition
4 Bottom mold
5 Upper mold
6 Cured product of curable composition
7 Support
8 LED element
9 Substrate
10 Arrayed optical module

To summarize the above, configurations of the present invention and variations thereof will be described below.
[1] An optical component array provided with an adhesive layer, the optical component array having a structure in which two or more optical components are arranged, the optical components each having an adhesive layer having heat- or photo-curability and having a storage modulus at 25°C from 0.05 × 10⁴ to 10000 × 10⁴ Pa on at least a part of a surface.
[2] The optical component array provided with an adhesive layer described in [1], where the lower limit of the storage modulus at 25°C of the adhesive layer is 0.1 × 10⁴ Pa, preferably 0.5 × 10⁴ Pa, and more preferably 1.0 × 10⁴ Pa and where the upper limit is 5000 × 10⁴ Pa, more preferably 3000 × 10⁴ Pa, particularly preferably 2000 × 10⁴Pa, and most preferably 1000 × 10⁴ Pa.
[3] The optical component array provided with an adhesive layer described in [1] or [2], where the thickness of the adhesive layer is 0.05 mm or greater (e.g., from 0.05 to 1.0 mm, preferably from 0.05 to 0.8 mm, more preferably from 0.2 to 0.8 mm, and particularly preferably from 0.2 to 0.6 mm).
[4] The optical component array provided with an adhesive layer described in any one of [1] to [3], where the thickness of the adhesive layer can be adjusted in a range from 20 to 100% (e.g., from 20 to 90%, preferably from 20 to 80%, and more preferably from 20 to 60%) by pressing force (e.g. vertically pressing a face with a force from 5 to 100 N/m²).
[5] The optical component array provided with an adhesive layer described in any one of [1] to [4], where the adhesive layer is formed from a heat- or photo-curable adhesive composition.
[6] The optical component array provided with an adhesive layer described in [5], where the heat- or photo-curable adhesive composition is at least one selected from the group consisting of acrylic resin adhesive compositions, epoxy resin adhesive compositions, and silicone-based resin adhesive compositions.
[7] The optical component array provided with an adhesive layer described in any one of [1] to [6], where each of the optical components is an optical component formed from a cured product of a curable composition containing an epoxy resin.
[8] The optical component array provided with an adhesive layer described in [7], where the epoxy resin is a polyfunctional alicyclic epoxy compound.
[9] The optical component array provided with an adhesive layer described in [7] or [8], where the epoxy resin is at least one selected from the group consisting of: (i) a compound having an epoxy group formed from two adjacent carbon atoms and an oxygen atom constituting an alicycle (alicyclic epoxy group); (ii) a compound having an epoxy group directly bonded to an alicycle through a single bond; and (iii) a compound having an alicycle and a glycidyl group.
[10] The optical component array provided with an adhesive layer described in any one of [7] to [9], where the epoxy resin is a compound represented by Formula (i) above (in the formula, X represents a single bond or a linking group).
[11] The optical component array provided with an adhesive layer described in any one of [7] to [10], where the curable composition containing the epoxy resin contains a curable compound except the epoxy resin, and the curable compound is a cationic curable compound, such as an oxetane compound or a vinyl ether compound.
[12] The optical component array provided with an adhesive layer described in any one of [7] to [11], where the proportion of the epoxy resin in the total amount (100 wt.%) of the curable compound contained in the curable composition containing the epoxy resin is 50 wt.% or greater, preferably 60 wt.% or greater, particularly preferably 70 wt.% or greater, and most preferably 80 wt.% or greater, and the upper limit is 100 wt.% and preferably 90 wt.%.
[13] The optical component array provided with an adhesive layer described in any one of [7] to [12], where the proportion of (i) the compound having an alicyclic epoxy group in the total amount (100 wt.%) of the curable compound contained in the curable composition containing the epoxy resin is 20 wt.% or greater, preferably 30 wt.% or greater, and particularly preferably 40 wt.% or greater, and the upper limit is 70 wt.% and preferably 60 wt.%.
[14] The optical component array provided with an adhesive layer described in any one of [7] to [13], where the proportion of the compound represented by Formula (i) in the total amount (100 wt.%) of the curable compound contained in the curable composition containing the epoxy resin is 10 wt.% or greater, preferably 15 wt.% or greater, and particularly preferably 20 wt.% or greater, and the upper limit is 50 wt.% and preferably 40 wt.%.
[15] The optical component array provided with an adhesive layer described in any one of [7] to [14], where the curable composition containing the epoxy resin contains a photopolymerization initiator (e.g., photocationic polymerization initiator).
[16] The optical component array provided with an adhesive layer described in any one of [7] to [15], where the content of the photopolymerization initiator is in a range from 0.1 to 5.0 parts by weight per 100 parts by weight of the curable compound (especially, cationic curable compound) contained in the curable composition containing an epoxy resin.
[17] The optical component array provided with an adhesive layer described in any one of [1] to [16], where the optical component array provided with an adhesive layer has a structure in which the two or more optical components having the adhesive layer on at least a part of the surface are arranged on a support.
[18] The optical component array provided with an adhesive layer described in any one of [1] to [17], where each of the optical components is a lens.
[19] The optical component array provided with an adhesive layer described in any one of [1] to [18], where the optical components each having the adhesive layer on at least a part of the surface are each a lens module having a structure in which a lens part, a flange part provided around an entire circumference of the lens part, and a spacer part provided along an outer periphery of the flange part are integrally molded; and also each a lens module provided with an adhesive layer, having an adhesive layer on at least a part of an upper edge face of the spacer part.
[20] A method for producing an optical component array provided with an adhesive layer to obtain the optical component array provided with an adhesive layer described in any one of [1] to [19], the method including the following steps:
   Step 1: subjecting a curable composition containing an epoxy resin to imprint molding to obtain an optical component array having a structure in which two or more optical components are arranged; and
   Step 2: forming an adhesive layer having a storage modulus at 25°C from 0.05 × 10⁴ to 10000 × 10⁴ Pa on at least a part of a surface of the obtained optical component array.
[21] A method for producing an arrayed optical module to obtain an arrayed optical module including a laminate of an optical component array and a substrate, the method including the following steps:
   Step I: laminating the optical component array provided with an adhesive layer described in any one [1] to [19] (a thickness of the adhesive layer: A) on a substrate, the adhesive layer being brought into contact with the substrate; and
   Step II: adjusting a distance between the optical components and the substrate by pressing the laminate of the optical component array provided with an adhesive layer and the substrate from above to adjust an adhesive layer thickness (B) in a range from 20 to 100% of (A) and by curing the adhesive layer by heat treatment and/or photoirradiation.
[22] The method for producing an arrayed optical module described in [21], where the optical component array is a lens array, the substrate is a substrate on which LED elements are mounted, and the arrayed optical module is an LED module provided with arrayed lenses.

### Industrial Applicability

By the virtue of having the structure described above, the optical component array provided with an adhesive layer according to an embodiment of present invention can be directly affixed to a substrate, can easily adjust the distance between the optical components and the substrate by controlling the pressing force during the affixing, and, by performing photoirradiation and/or heat treatment and curing the adhesive agent thereafter, can efficiently produce arrayed optical modules, in which the distance between the optical components and the substrate is maintained within a particular range, in a high yield.

## Claims

1. An optical component array provided with an adhesive layer, the optical component array comprising a structure in which two or more optical components each having an adhesive layer having heat- or photo-curability and having a storage modulus at 25°C from 0.05 × 10⁴ to 10000 × 10⁴ Pa on at least a part of a surface are arranged.

2. The optical component array provided with an adhesive layer according to claim 1, wherein each of the optical components is an optical component formed from a cured product of a curable composition containing an epoxy resin.

3. The optical component array provided with an adhesive layer according to claim 2, wherein the epoxy resin is a polyfunctional alicyclic epoxy compound.

4. The optical component array provided with an adhesive layer according to claim 2, wherein the epoxy resin is a compound represented by Formula (i): 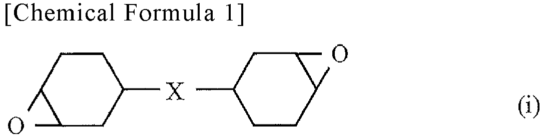 wherein, X represents a single bond or a linking group.

5. The optical component array provided with an adhesive layer according to any one of claims 1 to 4, wherein an adhesive layer thickness is 0.05 mm or greater, and the thickness can be adjusted in a range from 20 to 100% by pressing force.

6. The optical component array provided with an adhesive layer according to any one of claims 1 to 5, wherein the optical component array provided with an adhesive layer has a structure in which the two or more optical components having the adhesive layer on at least a part of the surface are arranged on a support.

7. The optical component array provided with an adhesive layer according to any one of claims 1 to 6, wherein each of the optical components is a lens.

8. The optical component array provided with an adhesive layer according to any one of claims 1 to 6, wherein the optical components each having the adhesive layer on at least a part of the surface are each a lens module having a structure in which a lens part, a flange part provided around an entire circumference of the lens part, and a spacer part provided along an outer periphery of the flange part are integrally molded; and also are each a lens module provided with an adhesive layer, having an adhesive layer on at least a part of an upper edge face of the spacer part.

9. A method for producing an optical component array provided with an adhesive layer to obtain the optical component array provided with an adhesive layer described in any one of claims 2 to 8, the method comprising:
Step 1: subjecting a curable composition containing an epoxy resin to imprint molding to obtain an optical component array having a structure in which two or more optical components are arranged; and
Step 2: forming an adhesive layer having a storage modulus at 25°C from 0.05 × 10⁴ to 10000 × 10⁴ Pa on at least a part of a surface of the obtained optical component array.

10. A method for producing an arrayed optical module to obtain an arrayed optical module comprising a laminate of an optical component array and a substrate, the method comprising:
Step I: laminating the optical component array provided with an adhesive layer described in any one of claims 1 to 8 (a thickness of the adhesive layer: A) on a substrate, the adhesive layer being brought into contact with the substrate; and
Step II: adjusting a distance between the optical components and the substrate by pressing the laminate of the optical component array provided with an adhesive layer and the substrate from above to adjust an adhesive layer thickness (B) in a range from 20 to 100% of (A) and by curing the adhesive layer by heat treatment and/or photoirradiation.

11. The method for producing an arrayed optical module according to claim 10, wherein the optical component array is a lens array, the substrate is a substrate on which an LED element is mounted, and the arrayed optical module is an LED module provided with arrayed lenses.
